# EUROPEAN PATENT APPLICATION

(11) **EP 4 704 153 A1**
(43) Date of publication of application: **04.03.2026**
(21) Application number: 24197961.6
(22) Date of filing: 02.09.2024
(51) Int. Cl.: H01L 25/065, G11C 5/02, G11C 5/14, H01L 23/522, H01L 25/18, H01L 23/498, H01L 25/00

(54) **A 3D INTEGRATED CIRCUIT DEVICE**

(71) Applicant: Imec VZW, 3001 Leuven (BE)
(72) Inventor: MYERS, James Edward, Great Wibraham, CB21 5JD (GB); GIACOMINI ROCHA, Leandro Mateus, 3000 Leuven (BE); BISWAS, Dwaipayan, 3001 Heverlee (BE)
(74) Representative: Lind Edlund Kenamets Intellectual Property AB

(57) **Abstract**

In an aspect there is provided a 3D IC device comprising:
a package wiring plane comprising a global VDD voltage node and a global VSS voltage node;
a die stack arranged over the package wiring plane and comprising a number of stacked dies stacked on top of each other;
a metal interconnect layer arranged on top of a top stacked die of the die stack; and
a pass-through interconnect extending vertically through each stacked die of the die stack and connecting the metal interconnect layer to the global VDD voltage node;
wherein each stacked die of the die stack has a bottom side and a top side, a local VDD voltage contact on its top side and a local VSS voltage contact on its bottom side,
wherein the local VSS voltage contact of a bottom stacked die of the die stack is connected to the global VSS voltage node, the local VSS voltage contact of each further stacked die is connected to the local VDD voltage contact of its neighboring stacked die below, and the local VDD voltage contact of the top stacked die is connected to the pass-through interconnect by the metal interconnect layer, such that the stacked dies of the die stack are voltage stacked between the global VDD and VSS voltage nodes

## Description

### TECHNICAL FIELD

The present disclosure relates to a 3D integrated circuit device. The present disclosure further relates to a method for forming a 3D integrated circuit device.

### BACKGROUND

There is a constant strive in the semiconductor industry to scale down the device dimensions to realize circuits with higher density and performance. Scaling by feature size reduction is becoming increasingly challenging and costly. Therefore, there is increasing interest in design and integration technologies for 3D integrated circuits (3D IC) comprising a plurality of dies stacked on top of each other. For instance, a system-on-chip (SOC) realized as a 3D IC may comprise a number of stacked dies wherein each is configured to implement a given circuit function (e.g., logic or memory).

An issue with 3D ICs is however that the power density increases with the number of dies of the stack, which in turn may increase the IR drop and require more power bump resources in the package, in proportion to the number of dies.

### SUMMARY

It is an object of the present invention to provide an improved 3D IC device allowing the number of stacked dies (i.e., the number of die levels of the 3D IC) to be increased and the current density and the number of package power bumps to be decreased. It is further an object to enable a 3D IC with a greater number of die levels to be realized at a reduced cost compared to conventional 3D IC designs.

According to a first aspect of the present invention, there is provided a 3D integrated circuit, IC, device comprising:
a package wiring plane comprising a global VDD voltage node and a global VSS voltage node;
a die stack arranged over the package wiring plane and comprising a number of stacked dies stacked on top of each other;
a metal interconnect layer arranged on top of a top stacked die of the die stack; and
a pass-through interconnect extending vertically through each stacked die of the die stack and connecting the metal interconnect layer to the global VDD voltage node;
wherein each stacked die of the die stack has a bottom side and a top side, a local VDD voltage contact on its top side and a local VSS voltage contact on its bottom side,
wherein the local VSS voltage contact of a bottom stacked die of the die stack is connected to the global VSS voltage node, the local VSS voltage contact of each further stacked die is connected to the local VDD voltage contact of its neighboring stacked die below, and the local VDD voltage contact of the top stacked die is connected to the pass-through interconnect by the metal interconnect layer, such that the stacked dies of the die stack are voltage stacked between the global VDD and VSS voltage nodes

Thereby, each stacked die of the die stack may be associated with or comprised in a respective voltage domain of the voltage stack, i.e., powered by respective local VDD and VSS voltages. The package voltage (i.e., the difference between the global VDD and VSS voltages) may hence be divided in a series manner across the stacked dies, such that each die sees a fraction of the package voltage, like in a potential divider.

The 3D IC may hence employ a higher package voltage at a lower current, which enables the voltage drop through the power delivery network (PDN) to be reduced, as it is proportional to the current and PDN resistance. Thus, the voltage drop through the PDN may be reduced without increasing the number of package bumps, which would incur footprint and financial penalties.

The voltage stacking may be realized using an interconnect structure of relatively low overall complexity, i.e., the metal interconnect layer on top of the top die and the pass-through interconnect which extends through each die of the die stack to directly connect the metal interconnect layer to the global VDD voltage node (thus electrically bypassing local connections within each die).

The metal interconnect layer may simply be configured to short the pass-through interconnect to the local VDD contact of the top stacked die. The metal interconnect layer may for example be realized as a redistribution layer (e.g., a single metal layer), which may be formed in a low complexity and low cost process on top of the top stacked die after forming the die stack.

The pass-through interconnect may for example comprise a plurality of through-silicon vias (TSVs), vertically stacked over each other and each extending through a respective die of the die stack. In the present disclosure, the term "TSV" refers to a via structure (i.e., a vertical electrical interconnect) extending through a substrate of a die, regardless of the type of semiconductor material of the substrate, consistent with its typical usage in the semiconductor industry.

In some embodiments, each stacked die of the die stack has a frontside and a backside and comprises a front-end-of-line (FEOL) structure and a frontside back-end-of-line, (BEOL) interconnect structure arranged on the FEOL structure, and wherein the stacked dies are stacked with the frontside BEOL interconnect structures facing in a same direction. The stacked dies may thus be stacked on top of each other in a regular fashion, e.g., face-to-back.

In some embodiments, the frontside is the bottom side of the stacked die. Hence, the stacked dies may be arranged with their respective frontsides and frontside BEOL structures facing the package wiring plane. This may be beneficial in particular in embodiments where the 3D IC further comprises a base die, as discussed below, comprising a backside power distribution network arranged on its backside and facing the package wiring plane. The backside PDN of the base die may then conveniently be connected to associated VSS and VDD supply voltage nodes of the package wiring plane, while the bottom stacked die may be arranged face-to-face with the base die.

In some embodiments, the frontside is rather the top side of the stacked die. Hence, the stacked dies may alternatively be arranged with their respective backsides facing the package wiring plane. This may contribute to a rational fabrication of the die stack since the metal interconnect layer then may be formed on top of the top stacked die at wafer-level, before dicing and stacking of dies on top of each other to form the die stack.

In some embodiments, the stacked dies are substantially identical dies.

Configuring the stacked dies as (substantially) identical dies further contributes to enabling a low cost and low complexity implementation of the 3D IC. Among others, the stacked dies may be manufactured in a rational manner using an (substantially) identical set of designs and masks. Furthermore, identical stacked dies facilitate distributing the package voltage (and thus the power) evenly across the stacked dies. This in turn reduces the need for incorporating voltage regulation circuits in each stacked die (although in some implementations some simple voltage regulation circuit may be useful, as discussed below).

In some embodiments, the stacked dies are memory dies.

The 3D IC may hence realize a memory circuit with a number of stacked memory dies. A base die as discussed below (thus being a control and/or I/O die for the memory dies) may implement peripheral circuitry of the memory circuit. A memory array is a type of circuit which lends itself well to a stacked implementation since the memory array may be divided into a plurality of sub-arrays with identical layouts. Hence, each stacked die may implement a respective sub-array of a memory array, wherein optionally, the stacked dies / sub-arrays may have a (substantially) identical layout. Further, realizing the stacked dies as memory dies may facilitate power balancing, for example by distributing read/write activity across all stacked (memory) dies, or by implementing redundant read/write operations.

In some embodiments, the stacked dies are logic dies.

The 3D IC may hence realize a logic-on-logic circuit. A base die as discussed below may implement a main set of logic functions and/or act as a control and/or I/O die for the stacked logic dies, and the stacked dies may implement auxiliary logic function, wherein optionally, the stacked dies may have a (substantially) identical layout and be configured to implement identical logic functions. The stacked dies may for instance implement accelerators (e.g., for accelerating matrix multiplications or other complex computational task). The activity of accelerators tends to be more deterministic than the activity of general logic circuitry, and may hence facilitate power balancing.

In some embodiments, the die stack further comprises a base die and the stacked dies are stacked on top of the base die,
wherein the base die is configured as a control and/or I/O die of the die stack and connected to each of the stacked dies, and
wherein the base die is connected between a second VSS voltage node and a local VDD voltage node of the package wiring plane, the local VDD voltage node being configured to supply a lower VDD voltage than the global VDD voltage node, and the second VSS voltage node being the global VSS voltage node or a local VSS voltage node.

In addition to the stacked dies (e.g., memory or logic dies, optionally identical), the die stack may comprise a base die arranged at the bottom of the die stack and configured as a controller or master of the stacked dies on top.

By connecting the base die between the local VDD voltage node and the global/local (i.e., "second") VSS voltage node, the base die may be designed more freely, with less regard to power consumption and voltage drop relative the stacked dies, as the base die need not be comprised in the voltage stack. Thus, it is not necessary to tailor the global VDD and VSS voltages, and the stacked dies such that the VSS voltage at the local VSS voltage contact of the bottom stacked die matches the VDD supply voltage requirements of the base die.

In some embodiments, the 3D IC further comprises:
a set of output signal routing structures extending through the die stack and configured to route output signals from the base die to each one of the stacked dies, and
a set of input signal routing structures configured to route input signals from the stacked dies to the base die.

Input and output signals may hence be routed using respective sets of signal routing structures extending through the die stack, e.g., between the base die and each respective stacked die. Thereby, the base die may exchange control and/or I/O signals with the stacked dies, e.g., to implement an intended circuit function.

Optionally, in some embodiments, the set of input and output signal routing structures may terminate at the top side of the top stacked die, and the metal interconnect layer may be arranged to be disconnected from the output signal routing structures and to short the input signal routing structures to the local VDD voltage contact of the top stacked die.

Floating of the inputs of the top stacked die (which does not have any further stacked die on top) may thus be avoided, as the inputs may be fixed to the local VDD supply voltage of the top stacked die (which corresponds to the global VDD supply voltage).

Meanwhile, shorting of the output signal routing structures to the local VDD supply voltage of the top stacked die may be avoided. This could otherwise result in incorrect data and/or increased power consumption, e.g., by causing competition between the output signals and the drive buffer/logic of the stacked die.

In some embodiments, the base die has a frontside facing the stacked dies and a backside facing the package wiring plane, and comprises a FEOL structure, a frontside (BEOL) interconnect structure arranged on the FEOL structure (on the frontside of the base die), and a backside power distribution network (arranged on the backside of the base die) and connected to the local VDD voltage node and the second VSS voltage node.

The backside PDN of the base die may thus conveniently be connected to the local VDD voltage node and the second (i.e., global or local) VSS voltage nodes of the package wiring plane. Meanwhile, competition between power routing sources and signal routing sources in the frontside interconnect structure of the base die may be reduced. As discussed above, this configuration of the base die may also be beneficial when combined with the stacked dies being arranged with their respective frontsides facing the package wiring plane.

In some embodiments, the local VSS voltage contact of the bottom stacked die is connected to the global VSS supply voltage node through the frontside interconnect structure and the backside power distribution network of the base die.

In some embodiments, the stacked dies are configured to have a substantially uniform power consumption during operation. This may contribute to a stable and uniform operation of the circuitry of each stacked die, and a uniform distribution of the package voltage across the stacked dies.

According to a second aspect of the present invention, there is provided a method for forming a 3D IC device, the method comprising:
arranging, over a package wiring plane comprising a global VDD voltage node and a global VSS voltage node, a die stack comprising a number of stacked dies stacked on top of each other,
   wherein each stacked die of the die stack has a bottom side and a top side, a local VDD voltage contact on its top side and a local VSS voltage contact on its bottom side,
   wherein the local VSS voltage contact of a bottom stacked die of the die stack is connected to the global VSS voltage node, the local VSS voltage contact of each further stacked die is connected to the local VDD voltage contact of its neighboring stacked die below, and
   wherein the die stack comprises a pass-through interconnect extending vertically through each stacked die of the die stack and connecting to the global VDD voltage node; and
forming a metal interconnect layer on top of the top stacked die for connecting the pass-through interconnect to the local VDD voltage contact of the top stacked die.

The method of the second aspect thereby enables fabrication of a 3D IC in accordance with the first aspect with the effects discussed in the above. In particular, the voltage stacking may be realized using a process of relatively low overall complexity; by shorting the pass-through interconnect to the local VDD contact of the top stacked die by forming the metal interconnect layer on top of the top stacked die. The metal interconnect layer may for example be realized as a redistribution layer (e.g., a single metal layer).

The die stack may be formed by stacking a number of wafers on top of each other to form a wafer stack, each comprising a respective one of the stacked dies, and subsequently dicing the wafer stack to form an individual / diced die stack.

The metal interconnect layer may be formed on top of the top stacked die prior to arranging the die stack over the package wiring plane. The metal interconnect layer may for instance be formed on a top wafer of the above-mentioned wafer stack prior to dicing.

Any further features, effects and examples discussed in relation to the first aspect in the present disclosure generally applies to the second aspect, unless stated otherwise.

### BRIEF DESCRIPTION OF THE DRAWINGS

The above, as well as additional objects, embodiments, features and advantages of the present disclosure, may be better understood through the following illustrative and non-limiting detailed description, with reference to the appended drawings.
Fig. 1 is a schematic cross-sectional view of a 3D IC.
Fig. 2 is a schematic cross-sectional view of a further 3D IC.
Fig. 3 is a flow chart of a method for forming a 3D IC.

### DETAILED DESCRIPTION

In the drawings, like reference numerals will be used for like or corresponding elements unless stated otherwise. The drawings are only schematic and the relative dimensions of illustrated elements, such as layers or other structures, may be exaggerated and not drawn to scale unless stated otherwise. Rather the dimensions may be adapted for illustrational clarity and to facilitate understanding. When present in the figures, the indicated axes X and Y point in a horizontal direction and a vertical direction, respectively.

In the present disclosure, the term "horizontal" refers to a direction parallel to a package wiring plane of a 3D IC. The term "lateral" may be used interchangeably with the term "horizontal". The term "vertical" refers to a direction normal or transverse to the package wiring plane. Accordingly, terms indicating relative vertical arrangement of elements, such as "top", "bottom", "above", "on top", "below", "underneath", and the like, are to be understood in relation to the vertical direction Y. For example, a "top" die is farther from the package wiring plane than a "bottom" die, a feature "above" another feature is farther from the package wiring plane than the other feature, etc. In general, the vertical direction Y corresponds to the direction in which the dies of the 3D IC are stacked over the package wiring plane.

In the present disclosure, when an element (e.g. a die or other structure) is referred to as being "on" another element, it can be directly on the other element or on one or more intermediate elements on the other element. Conversely, when an element is referred to as being "directly on" another element, there is no intermediate element and the element is thus formed in physical contact or abutment with the other element.

In the present disclosure, when two elements are said to be "connected" or "interconnected" it is meant that the elements are electrically connected or coupled, directly or via one or more intermediate conductive structures (e.g., interconnects), unless stated otherwise.

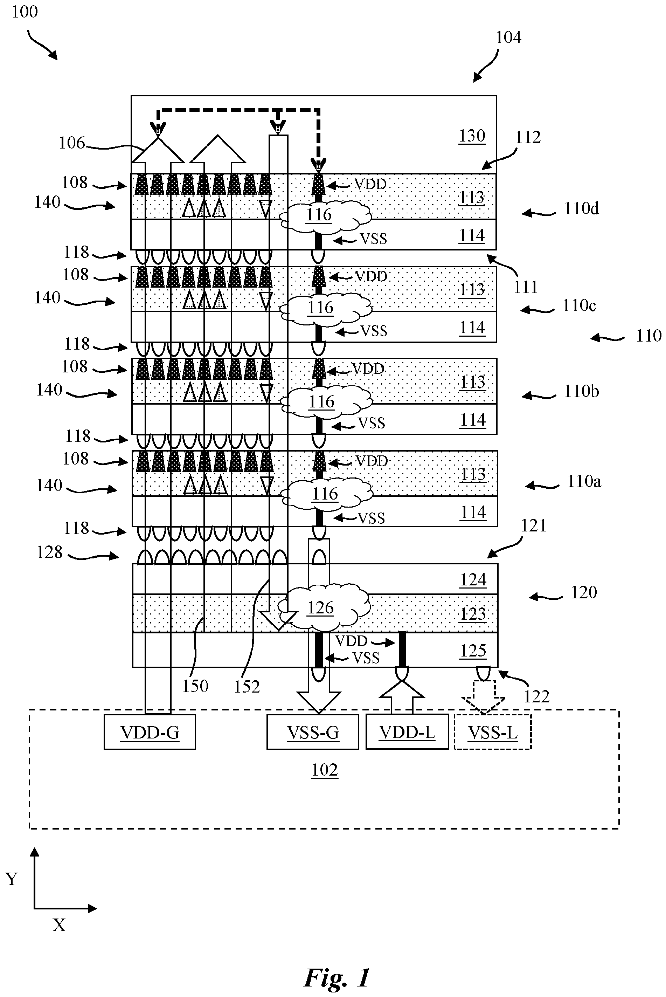

Fig. 1 is a schematic cross-sectional view of a 3D IC 100. The 3D IC 100 comprises a package wiring plane 102 and a die stack 104. The package wiring plane is in Fig. 1 depicted in a highly schematic manner by box 102. The package wiring plane 102 may for example be comprised in or defined by a wiring structure of a package substrate, a bottom redistribution layer (RDL) or an interposer of the 3D IC 100, to name a few non-limiting example implementations. The package wiring plane 102 comprises among others a global VDD voltage node VDD-G and a global VSS voltage node VSS-G.

In the present disclosure, the terms "VDD voltage node" and "VSS voltage node" refer to respective supply voltage nodes, or synonymously, power supplies or power rails of the 3D IC 100. More specifically, "VDD" refers to the higher (positive) supply voltage and "VSS" refers to the lower supply voltage, e.g., a reference supply voltage such as a ground level voltage (GND). A VDD voltage node may correspond to a pull-up supply voltage node / rail. A VSS voltage node may correspond to a pull-down supply voltage node / rail. In the present disclosure, reference is further made both to "global" and "local" VDD/VSS voltage nodes, where "global" is used to designate the higher VDD/VSS voltage domain of the 3D IC, which may be distributed across the die stack 104 as described herein. Meanwhile, "local" is used to designate a lower VDD/VSS voltage domain local to a die of the die stack 104.

The die stack 104 is arranged over the package wiring plane 102 and comprises a number of stacked dies 110 stacked on top of each other along the vertical direction Z. In the following, the reference sign 110 will be used as a common designation for anyone of the stacked dies 110 of the die stack 110, while a suffix "a", "b", etc. will be used to designate a specific stacked die of the die stack 104. Hence, when discussing features and examples applying to each stacked die 1 10a-d of the die stack 104, the reference sign 110 will typically be used. In the illustrated example, four stacked dies 110 are shown, comprising a bottom stacked die 110a, a top (i.e., a top-most) stacked die 110d, and two further intermediate stacked dies 110b, 110c. The illustrated number of stacked dies 110 is however merely a non-limiting example, and the number of stacked dies 110 may vary between different applications and configurations of the 3D IC 100, and may typically be much greater than four. For instance, in a memory application, it is contemplated that the number of stacked dies may be 32, 64 or greater. In any case, the die stack 110 comprises at least a bottom stacked die 110a and a top stacked die 110d, and, typically, a number of further intermediate stacked dies between the bottom and top stacked dies 110a, 110d.

The label "stacked", as in "stacked die", is here both used as a descriptive label of the stacked dies 110 in the sense that each die 110 is stacked over the package wiring plane 102 and forms part of the die stack 104, and also as a distinguish label to distinguish from a further optional base die 120 of the die stack 104, further discussed below. The stacked dies 110 and the base die 120 may also be referred to as auxiliary dies 110 and main die 120.

In the present disclosure, the term "die" is used to refer to a die structure or chip. As shown in Fig. 1, each stacked (auxiliary) die 110 has a frontside 111 and a backside 112 and comprises a front-end-of-line, FEOL, structure 113 and a frontside back-end-of-line (BEOL) interconnect structure 114 arranged on the FEOL structure 113. The frontside BEOL interconnect structure 114 is thus arranged on, or defines, the frontside 111 of the stacked die 110

In the present disclosure, the term "FEOL structure" is used to refer to a portion of a die / chip implementing active devices such as frontend transistors of the die / chip. Thus, the FEOL structure may comprise an active semiconductor layer of the die 110 (i.e., comprising the active regions or patterns of the frontend transistors), a gate layer (i.e., comprising the gates of the frontend transistors), and a local contact or interconnect layer (i.e., comprising the source/drain (S/D) contacts of the frontend transistors). The active regions may comprise S/D regions and channel regions of the frontend transistors. The active layer may be formed in a semiconductor substrate layer of the die. The semiconductor substrate layer may be formed by or comprised in any conventional CMOS compatible substrate, such as Si, Ge or SiGe substrate. Other non-limiting examples include a silicon-on-insulator (SOI) substrate, a GeOI substrate or a SiGeOI substrate. The frontend transistors may for instance comprise NMOSFETs and PMOSFETs (e.g, realized as FinFETs, nanosheet FETs or nanowire FETs). A die of a 3D IC in accordance with the present disclosure is however not limited to transistor devices, but may additionally comprise capacitors, non-transistor based selectors, diodes, volatile or non-volatile storage devices, magneto-resistive memory devices or other types of spintronic devices, etc., depending on the specific circuit function and implementation of the die.

Further, in the present disclosure, the term "BEOL structure" (or simply "interconnect structure") is used to refer to a vertical stack of interconnect layers of a die / chip, each comprising a dielectric layer embedding conductive elements (typically of metal) such as horizontally routed interconnects (traces or lines of a metal routing layer, such as M0, M1, etc.) or vertically routed interconnects ("vias" of a via layer, such as V0, V1, etc.) for providing vertical routing of signals between different metal routing layers, or between a routing layer and conductive elements of the FEOL structure 113. A "frontside" BEOL / interconnect structure of a die refers to an interconnect structure arranged on the frontside of the die, e.g., on the FEOL structure of the die. A "backside" BEOL / interconnect structure of a die refers to an interconnect structure arranged on the backside of the die.

The FEOL structure 113 and the frontside interconnect structure 114 together define the circuitry 116 of each stacked die 110. The stacked dies 110 may for example be stacked memory dies wherein the circuitry 116 of each memory die 110 may implement a sub-array of memory cells. In another example, the stacked dies 110 may be logic dies wherein the circuitry 116 may comprise logic circuitry, e.g., sequential and/or combinational logic. The stacked dies 116 may as a specific example be configured to implement computational tasks of a hardware accelerator.

The circuitry 116 of each stacked die 110 is connected between a local VDD voltage contact (VDD in Fig. 1, hereinafter for conciseness abbreviated "local VDD contact") and a local VSS voltage contact (VSS in Fig. 1, hereinafter for conciseness abbreviated "local VSS contact") of the respective stacked die 110. The local VDD and VSS contacts of each stacked die 110 are arranged on the backside 112 and the frontside 111, respectively, of the stacked die 110. As further described below, the local VDD and VSS contacts are configured to supply local VDD and VSS voltages to the associated stacked die 110 distributed through voltage stacking.

In Fig. 1, the stacked dies 110 are oriented with their respective frontsides 111 and BEOL structures 114 facing in a same direction. The stacked dies 110 are thus arranged face-to-back. More specifically, the frontsides 111 of the stacked dies 110 are all facing the package wiring plane 102 (i.e., in the negative Z direction). The frontside 111 of each stacked die 110 corresponds to the bottom side of the die 110 and the backside 112 corresponds to the top side of the die 110. With reference to the illustrated example, reference sign 111 may thus be used to refer to both the frontside and bottom side of a die 110, while reference sign 112 may be used to refer to both the backside and top side of a die 110.

While Fig. 1 schematically shows the local VDD and VSS contacts as single respective contacts of each stacked die 110, it is to be understood that each local VDD and VSS contact typically may be a contact structure or arrangement comprising a set of contact portions distributed across the respective die surfaces (i.e., frontside or backside) of the stacked dies 110.

The sets of VSS and VDD contact portions may be distributed in matching or corresponding patterns such that the sets of VSS contact portions and VDD contact portions of neighboring stacked dies 110 may electrically connect to each other. However, it is also possible to arrange the VDD and VSS contact portions in different patterns, provided some intermediate interconnect structure (e.g., an interposer and/or a RDL) is provided as an interface between neighboring stacked dies 110.

Realizing the local VDD and VSS contacts as contact arrangements comprising a set of plural contact portions may be beneficial as the local VDD and VSS voltages then may be directly supplied to plural locations of the circuitry 116 of each stacked die 110. This may reduce the need for providing routing resources in each stacked die 110 for routing of the local VDD and VSS voltages from the local VDD and VSS contacts across the plane of the stacked die 110.

The local VDD contacts of the stacked dies 110 may be implemented as backside contacts (e.g., sets of backside contacts) exposed at the respective backsides 112 of the stacked dies 110. The backside contacts may as indicated in Fig. 1 be provided in the form of TSVs 108, extending through the substrate of each stacked die 110. However, the local VDD contacts of the stacked dies 110 may also be implemented by contacts (e.g., vias) of a (local) backside power delivery network (BSPDN) which optionally may be provided on the backside 112 of each stacked die 110.

The local VSS contacts of the stacked dies 110 may be implemented as frontside contacts (e.g., sets of frontside contacts) arranged in the respective frontside interconnect structures 114 of the stacked dies 110. The frontside contacts may be arranged in a top layer of the frontside interconnect structures 114, more specifically at an interface of the frontside interconnect structure 114 towards the backside 112 of a neighboring stacked die 110 (or, for the bottom stacked die 110a, towards the frontside 121 of the base die 120). The frontside contacts may for instance be provided in the form of metal vias, islands or pads in the frontside interconnect structures 114.

The frontside and backside contacts of neighboring stacked dies 110 may as schematically indicated in Fig. 1 in turn be connected by inter-tier interconnects in the form of conductive bumps 118 arranged between the respective front and backsides 111, 112 of the stacked dies 110. The conductive bumps 118 may be realized as micro-bumps, solder balls, conductive pillars, or the like. Where the backside and frontside contacts are formed by pads, the inter-tier interconnection may also be formed by hybrid bond pads, i.e., hybrid bonding of the pads forming the backside and frontside contacts.

As mentioned above, the die stack 104 further comprises a base die or main die 120. The stacked (auxiliary) dies 110 are stacked on top of the base (main) die 120. The base die 120 may thus define the bottom-most die of the die stack 104.

As shown in Fig. 1, the base die 120 has a structure generally similar to each stacked die 110. Thus, the base die 120 has a frontside 121 and a backside 122. The base die 120 comprises a FEOL structure 123 and a frontside (BEOL) interconnect structure 124 arranged on the FEOL structure 123.

The frontside 121 and the frontside interconnect structure 124 of the base die 120 is arranged to face away from the package wiring plane 102 (i.e., in the +Z direction). Thus, as shown in Fig. 1, the base die 120 is arranged face-to-face (i.e., front-to-front) with the bottom stacked die 110a, while the stacked dies 110 are arranged face-to-back (i.e., front-to-back) with respect to each other. The frontside 121 of the base die 120 corresponds to the top side of the base die 120 and the backside 122 of the base die 120 corresponds to the bottom side of the base die 120. With reference to the illustrated example, reference sign 121 may thus be used to refer to both the frontside and top side of the base die 120, while reference sign 122 may be used to refer to both the backside and bottom side of the base die 120.

The FEOL structure 123 and the frontside interconnect structure 124 together define circuitry 126 of the base die 120. As further discussed below, the base die 120 is configured as a control and/or I/O die of the die stack 104. Thus, the circuitry 126 may implement control and/or I/O functionality of the base die 120.

The circuitry 126 is connected between a local VDD contact (designated VDD in Fig. 1) and a local VSS contact (designated VSS in Fig. 1). The local VDD and VSS contacts of the base die 120 are arranged in a backside power delivery network (BSPDN) of a backside interconnect structure 125 of the base die 120.

The local VDD and VSS contacts of the base die 120 may, analogous to the above discussion of the local VDD and VSS contacts of the stacked dies 110, be realized as local VDD and VSS contact arrangements comprising a set of contact portions. However, in contrast to the stacked dies 110, the base die 120 does not form part of the voltage stack, as further described below. Rather, the local VDD and VSS contacts of the base die 120 are configured to supply local VDD and VSS voltages provided directly via respective voltage nodes of the package wiring plane 102.

The local VDD contact VDD of the base die 120 is as shown connected to a local VDD voltage node VDD-L of the package wiring plane 102. The local VDD voltage node VDD-L will typically be configured to supply a lower VDD voltage than the global VDD voltage node VDD-G.

The local VSS contact of the base die 120 is as shown connected to the global VSS voltage node VSS-G. Thus, the base die 120 and the bottom stacked die 110 may have a common VSS voltage.

Alternatively, the local VSS contact of the base die 120 may (as shown in dashed outline line) be connected to an optional local VSS voltage node VSS-L of the package wiring plane 102. This may allow the local VSS voltage of the base die 120 to be set independently from the global VSS voltage, which may facilitate noise isolation (in particular if the base die 120 includes dense analog and/or high-speed IO circuitry).

Accordingly, to summarize, the base die 120 is connected between the local VDD voltage node VDD-L of the package wiring plane 102 and a second VSS voltage node, where the second VSS voltage node may be either the global VSS voltage node VSS-G or a separate local VSS voltage node VSS-L of the package wiring plane 102.

The base die 120 may as shown further comprise a set of inter-tier interconnects 128 configured to interconnect the bottom stacked die 110a (e.g., frontside contacts of the frontside interconnect structure 114 of the bottom stacked die 110a) and the base die 120 (e.g., frontside contacts, such as metal vias, islands or pads, of the frontside interconnect structures 124 of the base die 120). The inter-tier interconnection may be realized in a same manner as described for the inter-tier interconnects 118.

The 3D IC 100 further comprises a metal interconnect layer 130 arranged on top of the top stacked die 110d of the die stack 104. The 3D IC 100 further comprises a pass-through interconnect 106 extending vertically (along the Z direction) through each stacked die 110 of the die stack 104 to connect the metal interconnect layer 130 to the global VDD voltage node VDD-G.

The metal interconnect layer 130 may for example be realized as a redistribution layer (RDL), e.g., of aluminum or any other conventional metal typically employed for RDLs. Another implementation would be to realize the metal interconnect layer 130 as a metal routing layer embedded in a dielectric layer, analogous to a metal routing layer of a BEOL structure. Albeit somewhat more complex and expensive than a RDL from a manufacturing point-of-view, it may allow a more flexible interconnection between the pass through-interconnect 106 and the local VDD contact VDD of the top stacked die 110d. This may in particular be beneficial where the local VDD contact VDD of the stacked dies 110 comprises a plurality of distributed contact portions.

The pass-through interconnect 106 refers to a substantially vertically routed interconnect structure. The pass-through interconnect 106 is configured to connect the metal interconnect layer 130 to the global VDD voltage node VDD-G while electrically by-passing each of the stacked dies 110 and the base die 120. That is, there is no direct electrical connection between any portion of the pass-through interconnect 106 and the circuitry 116, 126 of the stacked dies 110 and the base die 120. Thus, the portion of the pass-through interconnect 106 extending through a respective stacked die 110 (or the base die 116) extends through the respective die 110 (or 116) without connecting to the further circuitry 116 (or the circuitry 126) of the respective die 110 (or 116).

The pass-through interconnect 106 may for example comprise a plurality of TSVs 108, vertically stacked over each other and each extending through a respective stacked die 110 of the die stack 104. In Fig. 1, the TSVs of the stacked dies 110 are indicated to extend only through a lower portion of each stacked die 110. The TSV 108 of a stacked die 110 may in this case extend through the substrate of the stacked die 110 and connect (e.g., by an abutting connection) to a contact structure arranged in the interconnect structure 114 of the stacked die 110, and optionally also in the FEOL structure 113 depending on the vertical extension (i.e., height) of the TSV 108. Where the contact structure is comprised in the interconnect structure 114, and optionally the FEOL structure 113, it is noted that such contact structure does not form part of or define the circuitry 116 mentioned above but is electrically disconnected from the circuitry 116 within the respective die 110. The contact structure may comprise a combination of vias and, optionally, intermediate metal islands of the interconnect structure 114. The contact structure may be arranged to extend through the interconnect structure 114 of the stacked die 110 to define a frontside contact (e.g., in the form of a metal via, island or pad) in a top layer of the frontside interconnect structure 114, more specifically at an interface of the frontside interconnect structure 114 towards the backside 112 of a neighboring stacked die 110 (or, for the bottom stacked die 1 10a, towards the frontside 121 of the base die 120). The frontside contact may in turn be connected to the TSV 108 of the stacked die 110 underneath by an inter-tier interconnect, e.g. a conductive bump 118.

It is also possible to form the TSVs 108 of each respective stacked die 110 comprised in the pass-through interconnect 106 to extend completely through the stacked die 110, from the backside 112 to the frontside 111 of the stacked die 110. Thus, each TSV 108 of the pass-through interconnect 106 may define a frontside contact and a backside contact at its bottom and top surface, abutting a TSV 108 of a neighboring stacked die 110.

While reference in the above is made to a pass-through interconnect 106 comprising a single TSV 108 of each stacked die 110, it is to be noted that the pass-through interconnect may comprise a plurality of TSVs 108 of each stacked die 110. This may enable a pass-through interconnect 106 with an increased cross-sectional dimension and in turn reduced IR drop.

While not expressly shown in Fig. 1, the pass-through interconnect 106 may comprise a corresponding set of TSV(s), and, optionally, contact structure(s) extending through the base die 120 to contact the global VDD voltage node VDD-G. However, the specific implementation of the connection to the global VDD voltage node VDD-G may vary. For instance, the pass-through interconnect 106 need not extend through the base die 120, but rather terminate at and abut a subset of the contact structure(s) 128 of the base die 120 which in turn may be connected to the global VDD voltage node VDD-G through a combination of vertically and (optionally) horizontally routed interconnects of the frontside interconnect structure 124, the FEOL structure 123 and (where present) the backside interconnect structure 125 of the base die 120.

Still with reference to Fig. 1, and starting from the bottom stacked die 110a, its local VSS contact is as shown connected to the global VSS voltage node VSS-G through the base die 120, as schematically indicated by the downwardly oriented arrow extending between the local VSS contact of the bottom stacked die 110a and the global VSS voltage node VSS-G.

For instance, the local VSS contact of the bottom stacked die 110a may be connected to a corresponding contact (or contact arrangement) of the frontside interconnect structure 124 of the base die 120, and further be connected through the circuitry 126 of the base die 120 and the BSDPN of the backside interconnect structure 125 to the global VSS voltage node VSS-G in the package wiring plane 102. Where the base die 120 and the bottom stacked die 110 are configured to have a common VSS voltage supply, the local VSS contact of the bottom stacked die 110a may be connected to the local VSS contact VSS of the base die 120.

Moving upward in the die stack 104, the respective local VSS contact VSS of each further stacked die 110 (e.g., stacked dies 110b, 110c, 110d) is connected to the local VDD contact VDD of its neighboring stacked die below (e.g., stacked dies 110a, 110b, 110c). Finally, the local VDD contact VDD of the top stacked die 110d is connected to the pass-through interconnect 106 by the metal interconnect layer 130. Thereby, the stacked dies 110 of the die stack 104 are connected in series between the global VDD and VSS voltage nodes VDD-G, VSS-G so as to be voltage stacked therebetween. That is, the stacked dies 110 are voltage stacked such that the voltage between the global VDD and VSS voltage nodes VDD-G and VSS-G (i.e., the package voltage) is divided across each stacked die 110.

Assuming by way of example that the global VDD voltage supplied by the global VDD voltage node VDD-G is 4 V and the global VSS voltage node VSS-G is 0 V, and further assuming a substantially uniform voltage drop across each stacked die 110, the voltage across each stacked die 110 will be approximately 1 V. That is:
- the local VDD and VSS voltages of the bottom stacked die 110a will be approximately 1 V and 0 V, respectively,
- the local VDD and VSS voltages of the further stacked die 110b will be approximately 2 V and 1 V, respectively,
- the local VDD and VSS voltages of the further stacked die 110c will be approximately 3 V and 2 V, respectively, and
- the local VDD and VSS voltages of the top stacked die 110d will be approximately 4 V and 3 V, respectively.

As would be appreciated by the skilled person, different global VDD and VSS voltages and different numbers of stacked dies 110 would result in a different voltage distribution.

In general, the global VDD and VSS voltages may be chosen in view of factors such as the number of stacked dies 110, the power requirements and expected voltage drop of each stacked die 110, etc.

The local VDD and VSS supply voltages for the base die 120 may for example be approximately 0.7-1 V and 0 V, respectively, and thus appropriate for core logic and IO circuitry.

The stacked dies 110 may be configured to provide a substantially uniform voltage drop between their respective local VDD and VSS contacts. In other words, the stacked dies 110 may be configured to have a substantially uniform power consumption during operation or runtime. This may contribute to a stable and uniform operation of the circuitry 116 of each stacked die 110. It may further reduce the need for incorporating voltage regulation circuits in each stacked die 110 for adapting the voltage supplied by a neighboring stacked die 110.

One approach which may facilitate a uniform voltage drop / power consumption of the stacked dies 110 is to configure the stacked dies 110 as substantially identical dies. That is, the circuitries 116 of the stacked dies 110 may have a substantially identical layout. The "layout" here refers to the combined layouts of the FEOL structure 113 (e.g., the layout of the active semiconductor layer, the gate layer, the local interconnect layer) and of the frontside interconnect structure 114 (and backside interconnect structure if present). Accordingly, two or more circuitries 116 with substantially identical layouts may be defined by the same netlists and floorplans, and may be fabricated using a same combination of masks and process steps. Thereby, an impedance between the respective local VDD and VSS contacts of the stacked dies 110 may be substantially uniform or equal for the stacked dies 110.

An alternative or supplementary approach is to implement a power balancing circuit in the circuitry 126 of the base die 120. The power balancing circuit may be configured to balance or equalize the power distributed to each stacked die 110 during operation. The power balancing circuit may monitor circuit activity and distribute the activity substantially uniformly or evenly across the stacked dies 110. Where a functional operation is desired only in one or a subset of the stacked dies 110, the power balancing circuit may be configured to cause redundant operation with similar power consumption in the other stacked dies 110.

Identical stacked dies 110, as well as power balancing, may in particular be suitable in memory applications, where the stacked dies 110 may be configured to implement identical sub-arrays of a memory array. Read/write activity and/or redundant read/write operations may then be distributed in a straightforward manner between the stacked dies 110. A further application suitable for implementations with identical stacked dies 110 and/or power balancing is hardware accelerators, where the stacked dies 110 may be configured to implement identical computational tasks of the accelerator.

As mentioned above, the base die 120, i.e., its circuitry 126, is configured to implement control and/or I/O functionality. The circuitry 126 is connected to each of the stacked dies 110. Thus, the base die 126 may supply control signals to, and receive and process signals (e.g., data) from, the stacked dies. For example, where the stacked dies 110 are memory dies, the circuitry 126 of the base die 120 may be configured to implement a memory and I/O controller for the stacked memory dies 110. As another example, where the stacked dies 110 are logic dies, the circuitry 126 of the base die 120 may be configured to implement main control and logic functionality and distribute tasks between the stacked logic dies 110.

To facilitate exchange of signals with the stacked dies 110, the 3D IC device 100 comprises a set of output signal routing structures 150 extending through the die stack 104 and configured to route output signals from the circuitry 126 of the base die 120 to respective the circuitry 116 of each one of the stacked dies 110. The 3D IC device 100 further comprises a set of input signal routing structures 152 configured to route input signals from the respective circuitry 116 of each one of the stacked dies 110 to the circuitry 126 of the base die 120. For example, in a memory application, the input signal routing structures 152 may for example route read data signals from the stacked memory dies 110 to the base die 120, while the output signal routing structures 150 may route write data signals from the base die 120 to the stacked memory dies 110.

Each of the set of input and output signal routing structures 150, 152 may comprise a combination of TSVs 108, inter-tier interconnects (e.g., conductive bumps 118), metal lines and vias of the interconnect structures 114 of the stacked dies 110, and any further circuitry connected between the circuitry 126 of the base die 120 and respective inputs/outputs (e.g., input/output buffers) of the stacked dies 110 (e.g., level shifters 140). Hence, while Fig. 1 schematically shows the set of input and output signal routing structures 150, 152 as separate from and displaced with respect to the outline of the circuitry 116, it is to be understood that the set of input and output signal routing structures 150, 152 comprised in each respective stacked die 110 may be comprised in, or form part of, the circuitry 116 of the stacked dies 110. Thus, while the pass-through interconnect 106 is configured to supply the global VDD voltage along a substantially strictly vertical path, the set of input and output signal routing structures 150, 152 may be configured to allow an overall vertical propagation of signals to/from the base die 120 including vertical as well as horizontally oriented segments.

The set of input and output signal routing structures 150, 152 may as shown terminate at the top side 112 of the top stacked die 110d. To avoid shorting of the output signal routing structures 150 (and thus the corresponding input buffers of the circuitry 116 of the stacked dies 110) to the pass-through interconnect 106 (and thus to the global VDD voltage node VDD-G), the metal interconnect layer 130 may be arranged to be disconnected from the output signal routing structures 150. For instance, where the metal interconnect layer 130 is an RDL, the RDL may be arranged to not cover the top side 112 of the top stacked die 110d in areas exposing the output signal routing structures 150.

On the other hand, to avoid a floating of the inputs of the top stacked die 110d (which in the lower stacked dies 1 10a-c are connected to the outputs of the upper stacked dies 1 10b-d) the metal interconnect layer 130 may be arranged to short the input signal routing structures 152, more specifically input nodes of the input signal routing structures 152 at the top side 112 of the top stacked die 110d, to the local VDD voltage contact VDD of the top stacked die 110d. In other words, the input signal routing structures 152 may be shorted to the pass-through interconnect 106 (and thus to the global VDD voltage node VDD-G) at the top side 112 of the top stacked die 110d. For instance, where the metal interconnect layer 130 is an RDL, the RDL may be arranged to extend continuously between the areas exposing (the input nodes of) the input signal routing structures 152 and the local VDD voltage contact VDD of the top stacked die 110d.

To control the flow of signals between the base die 120 and the stacked dies 110, the circuitry 116 of each stacked die 110 may comprise a multiplexer connected to the input and output signal routing structures 150, 152. A multiplexer of a stacked die 110 may for example be configurable (e.g., responsive to control signals supplied by the base die 120 via the output signal routing structure 150) to output either data generated by its circuitry 116, or data generated by and received from the circuitry 116 of the neighboring stacked die 110 above via the input signal routing structure 152.

To ensure that logic signals routed via the input and output signal routing structures 150, 152 are represented by voltage levels appropriate for the respective voltage domain of each stacked die 110, each stacked die 110 may further comprise level shifters, both up- and down-shifters. A level-down shifter may be configured to down-shift a logic low or logic high level voltage received by a first stacked die 110 (e.g., 110a) from its neighboring second stacked die 110 above (e.g., 110b) to the voltage domain of the first stacked die 110. The logic low or logic high level voltage received from the second stacked die 110 (e.g., 110b) corresponds to the local VSS and VDD, respectively, of the second stacked die 110. The logic low or logic high level voltage of the first stacked die 110 (e.g., 110a) corresponds to the local VSS and VDD, respectively, of the first stacked die 110. Thus, as an example, if the stacked die 110b is supplied by local VDD and VSS voltages of 2 V and 1 V, respectively, a logic high level ("1") may be represented by 2 V and a logic low level ("0") may be represented by 1 V in the circuitry 116 of the stacked die 110b. In turn, the stacked die 110a is supplied by local VDD and VSS voltages of 1 V and 0 V, respectively, wherein a logic high level ("1") may be represented by 1 V and a logic low level ("0") may be represented by 0 V in the circuitry 116 of the stacked die 1 10a. Thus, if the stacked die 110a receives 1 V from the stacked die 110b, it would be interpreted incorrectly as a logic 1. By a level-down shifter, input voltages of 2 V and 1 V received from the stacked die 110b may be shifted to 1 V and 0 V and thus correctly represented as logic 1 and 0, respectively, in the circuitry 116 of stacked die 110a. A level-up shifter may be configured in an analogous manner for up-shifting logic low or logic high level voltages received by the second stacked die 110 (e.g., 110b) from the neighboring first stacked die 110 below (e.g., 110a).

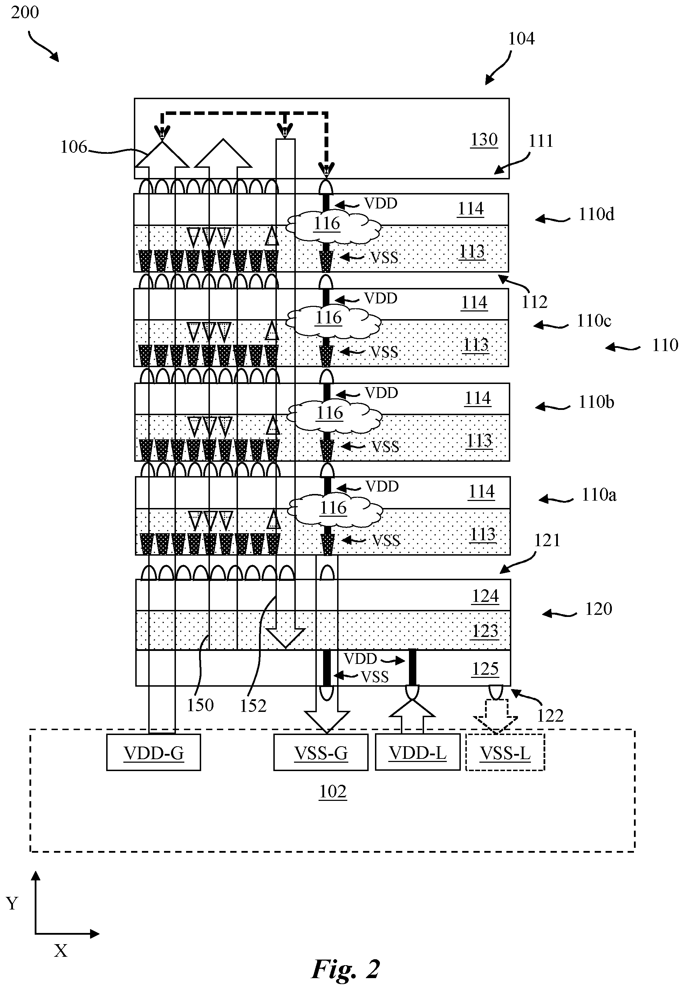

Fig. 2 is a schematic cross-sectional view of a further 3D IC 200. The 3D IC 200, like the 3D IC 100, comprises a die stack 104 comprising a base die 120 and a number of stacked dies 110 stacked on top of the base die 120. The above description of the 3D IC 100 generally applies correspondingly to the 3D IC 200. However, the 3D IC 200 differs from the 3D IC 100 in that the stacked dies 110 here are arranged with their respective frontsides 111 and FEOL structures 113 facing away from the package wiring plane 102 (i.e., in the +Z direction), that is, in a same direction as the base die 120. The frontside 111 of each stacked die 110 corresponds to the top side of the die 110 and the backside 112 corresponds to the bottom side of the die 110. With reference to the illustrated example, reference sign 111 may thus be used to refer to both the frontside and top side of a die 110, while reference sign 112 may be used to refer to both the backside and bottom side of a die 110.

Hence, in both the 3D IC 100 and the 3D IC 200, the stacked dies 110 are arranged face-to-back. However, whereas in the 3D IC 100 the frontsides 111 of the stacked dies 110 are facing the package wiring plane 102 and the base die 120, in the 3D IC 200 the frontsides 111 of the stacked dies 110 are facing away from the package wiring plane 102 and the base die 120. Thus, as shown in Fig. 2, the base die 120 is arranged face-to-back with the bottom stacked die 110a.

As a consequence of the "face-up" orientation of the stacked dies 110, the metal interconnect layer 130 is here arranged on top of the frontside 11 of the top stacked die 110d. More specifically, the metal interconnect layer 130 is arranged on top of the frontside interconnect structure 114 of the top stacked die 110d.

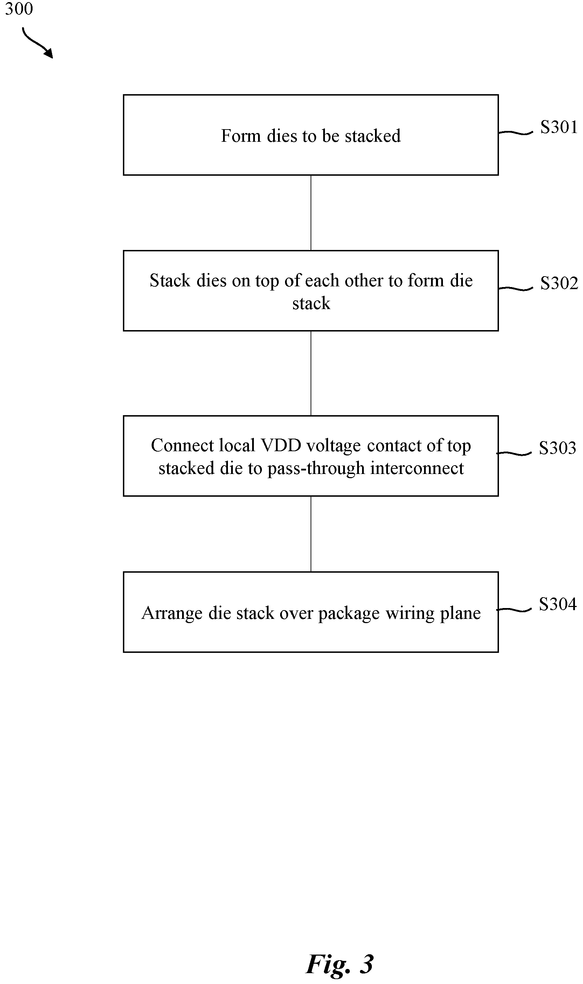

Fig. 3 is a flow chart of a method 300 for forming a 3D IC, such as the 3D IC 100 or 200 of Fig. 1 and 2, respectively. Hence, to facilitate understanding, like reference signs will in the description of Fig. 3 be used to refer to like features of Fig. 1 and 2.

The method 300 comprises, at S301, to form the dies to be stacked to form the die stack. The dies may comprise the "stacked" dies 110 and the base die 120. The stacked dies 110 may as discussed above be formed with substantially identical layouts. Hence, the stacked dies 110 may be formed using a substantially identical set of circuit layouts, designs, netlists, and masks. The base die 120 will typically have a different layout than the stacked dies 110 and may thus be formed using a different set of circuit layouts, designs, netlists, and masks. The fabrication of the dies to be stacked may comprise conventional CMOS processing techniques, including FEOL and BEOL processes. The dies may be formed on a plurality of different wafers which are to stacked and bonded to each other in a subsequent step. Thus, a number of wafers may be formed comprising a plurality of stacked dies 110, and one further "base" wafer comprising a plurality of base dies 120.

At S302, the dies 110, 120 formed at S301 are stacked on top of each other to form the die stack, such as the die stack 104. Forming the die stack 104 may comprise performing wafer-level stacking of the dies 110, 120 formed in step S301. Thus, a number of wafers, each comprising a plurality of stacked dies 110, may be stacked with a base wafer comprising a plurality of base dies 120.

At S303, the local VDD voltage contact VDD of the top stacked die 110d of the die stack 104 is connected to the pass-through interconnect by forming a metal interconnect layer 130 (e.g., a RDL) on top of the top stacked die 110d. Where a wafer-level stacking of the dies 110, 120 is employed at step S302, the metal interconnect layer 130 may be formed on the top stacked wafer of the wafer stack (the top stacked wafer referring to the wafer comprising the plurality of top stacked dies 1 10d) such that the respective local VDD voltage contact VDD of each top stacked die 110d is connected to the respective pass-through interconnect of extending through the respective die stack. The thus formed stack of wafers may subsequently be diced, to form a plurality of individual die stacks 104, each comprising a respective metal interconnect layer 130.

At S304, the die stack 104 (i.e., each die stack 104 in case multiple die stacks 104 are diced from a wafer stack) is arranged over a package wiring plane 102 of a (respective) chip package such that the pass-through interconnect is connected to the global VDD voltage contact VDD-G of the package wiring plane, and the stacked dies 110 of the die stack 104 are voltage stacked between the global VDD and VSS voltage nodes VDD-G, VSS-G of the package wiring plane 102.

As an alternative to forming the metal interconnect layer 130 prior to dicing, it is also possible to form a respective metal interconnect layer 130 on top of the top stacked die 110d of each respective die stack 104 after dicing.

The person skilled in the art realizes that the present invention by no means is limited to the examples described above. On the contrary, many modifications and variations are possible within the scope of the appended claims. For example, while both 3D IC devices 100 and 200 comprise a base die 120 as the bottom-most die of the die stack 104, it is envisaged that the present disclosure is applicable also to other configurations. For instance, instead of arranging the base die 120 underneath the stacked dies 110, it is possible to arrange a base die with a functionality corresponding to the base die 120 over package wiring plane 102, but adjacent the die stack 104. The base die may then be connected to the die stack 104 using an interposer and/or RDL.

## Claims

1. A 3D integrated circuit, IC, device (100) comprising:
a package wiring plane (102) comprising a global VDD voltage node (VDD-G) and a global VSS voltage node (VSS-G);
a die stack (104) arranged over the package wiring plane (102) and comprising a number of stacked dies (110) stacked on top of each other;
a metal interconnect layer (130) arranged on top of a top stacked die (110d) of the die stack (104); and
a pass-through interconnect (106) extending vertically through each stacked die (110) of the die stack (104) and connecting the metal interconnect layer (130) to the global VDD voltage node (VDD-G);
wherein each stacked die (110) of the die stack (104) has a bottom side (111) and a top side (112), a local VDD voltage contact (VDD) on its top side and a local VSS voltage contact (VSS) on its bottom side,
wherein the local VSS voltage contact (VSS) of a bottom stacked die (110a) of the die stack (104) is connected to the global VSS voltage node (VSS-G), the local VSS voltage contact (VSS) of each further stacked die (1 10b-c, 110d) is connected to the local VDD voltage contact (VDD) of its neighboring stacked die below, and the local VDD voltage contact (VDD) of the top stacked die (110d) is connected to the pass-through interconnect (106) by the metal interconnect layer (130), such that the stacked dies (110) of the die stack (104) are voltage stacked between the global VDD and VSS voltage nodes (VDD-G, VSS-G).

2. The 3D IC (100) according to claim 1, wherein each stacked die (110) of the die stack has a frontside and a backside and comprises a front-end-of-line, FEOL, structure (113) and a frontside back-end-of-line, BEOL interconnect structure (114) arranged on the FEOL structure (113), and wherein the stacked dies (110) are stacked with the frontside BEOL interconnect structures (113) facing in a same direction.

3. The 3D IC (100) according to claim 2, wherein the frontside is the bottom side (111) of the stacked die (110).

4. The 3D IC (200) according to claim 2, wherein the frontside is the top side (112) of the stacked die (110).

5. The 3D IC (100) according to any one of the preceding claims, wherein the stacked dies (110) are substantially identical dies.

6. The 3D IC according to any one of the preceding claims, wherein the stacked dies (110) are memory dies.

7. The 3D IC according to any one of the preceding claims, wherein the stacked dies (110) are logic dies.

8. The 3D IC (100) according to any one of the preceding claims,
wherein the die stack (104) further comprises a base die (120) and the stacked dies (110) are stacked on top of the base die (120),
wherein the base die (120) is configured as a control and/or I/O die of the die stack and connected to each of the stacked dies (110), and
wherein the base die (120) is connected between a second VSS voltage node and a local VDD voltage node (VDD-L) of the package wiring plane (102), the local VDD voltage node being configured to supply a lower VDD voltage than the global VDD voltage node, and the second VSS voltage node being the global VSS voltage node (VSS-G) or a local VSS voltage node (VSS-L).

9. The 3D IC according to claim 8, further comprising:
a set of output signal routing structures (150) extending through the die stack (104) and configured to route output signals from the base die (120) to each one of the stacked dies (110), and
a set of input signal routing structures (152) configured to route input signals from the stacked dies (110) to the base die (120);

10. The 3D IC according to claim 9, wherein the set of input and output signal routing structures (150, 152) terminate at the top side (112) of the top stacked die (1 10d), and wherein the metal interconnect layer (130) is arranged to be disconnected from the output signal routing structures (150) and to short the input signal routing structures (152) to the local VDD voltage contact of the top stacked die (110d).

11. The 3D IC (100) according to any one of claims 8-10, wherein the base die (120) has a frontside (121) facing the stacked dies (110) and a backside (122) facing the package wiring plane (102), and comprises a front-end-of-line, FEOL, structure (123), a frontside back-end-of-line, BEOL, interconnect structure (124) arranged on the FEOL structure (123), and a backside power distribution network (125) connected to the local VDD voltage node (VDD-L) and the second VSS voltage node (VSS-G, VSS-L).

12. The 3D IC (100) according to claim 11, wherein the local VSS voltage contact (VSS) of the bottom stacked die (110a) is connected to the global VSS supply voltage node (VSS-G) through the frontside interconnect structure (124) and the backside power distribution network (125) of the base die (120).

13. The 3D IC (100) according to any one of the preceding claims, wherein the metal interconnect layer (130) is a redistribution layer.

14. A method for forming a 3D integrated circuit, IC, device, the method comprising:
arranging, over a package wiring plane comprising a global VDD voltage node and a global VSS voltage node, a die stack comprising a number of stacked dies stacked on top of each other,
wherein each stacked die of the die stack has a bottom side and a top side, a local VDD voltage contact on its top side and a local VSS voltage contact on its bottom side,
wherein the local VSS voltage contact of a bottom stacked die of the die stack is connected to the global VSS voltage node, the local VSS voltage contact of each further stacked die is connected to the local VDD voltage contact of its neighboring stacked die below, and
wherein the die stack comprises a pass-through interconnect extending vertically through each stacked die of the die stack and connecting to the global VDD voltage node; and
forming a metal interconnect layer on top of the top stacked die for connecting the pass-through interconnect to the local VDD voltage contact of the top stacked die.
